# EUROPEAN PATENT APPLICATION

(11) **EP 2 302 402 A1**
(43) Date of publication of application: **30.03.2011**
(21) Application number: 09794130.6
(22) Date of filing: 02.06.2009
(51) Int. Cl.: G01R 15/20

(54) **CURRENT SENSOR**

(30) Priority: 08.07.2008 JP 2008178046
(71) Applicant: Panasonic Corporation, Kadoma-shi Osaka 571-8501 (JP)
(72) Inventor: MORIMOTO, Naohisa, Chuo-ku, Osaka-shi, Osaka 540-6207 (JP)
(74) Representative: TBK-Patent
(86) International application number: PCT/JP2009/002446
(87) International publication number: WO 2010/004682

(57) **Abstract**

A current sensor 1 is provided with: a core 3 for collecting magnetic flux generated by a target current; a Hall element 2 for outputting an electric signal corresponding to the amount of the magnetic flux collected by the core 3; a circuit board 4; and a cabinet 5 for accommodating the above components. The cabinet 5 is made of, for example, an insulating material. Provided on the circuit board 4 is the Hall element 2 and an amplifier for amplifying the output signal from the Hall element 2. Also, arranged between the core 3 and the circuit board 4 is a connecting line 9 for allowing static electricity, which has transferred from the cabinet 5 made of an insulating material to the core 3, to escape to the circuit board 4.

## Description

### [Field of invention]

The present invention relates to a current sensor, and more specifically, relates to a technique for protecting a current sensor using a Hall element from static electricity.

### [Background of Invention]

A current sensor using a Hall element is utilized in various fields for reasons such as: (1) having excellent insulation, with complete insulation of the conductor through which a target current flows and of the output circuit of the current sensor; (2) being capable of high-preasion detection; (3) being fast in response speed; and (4) loss of the target current being small.

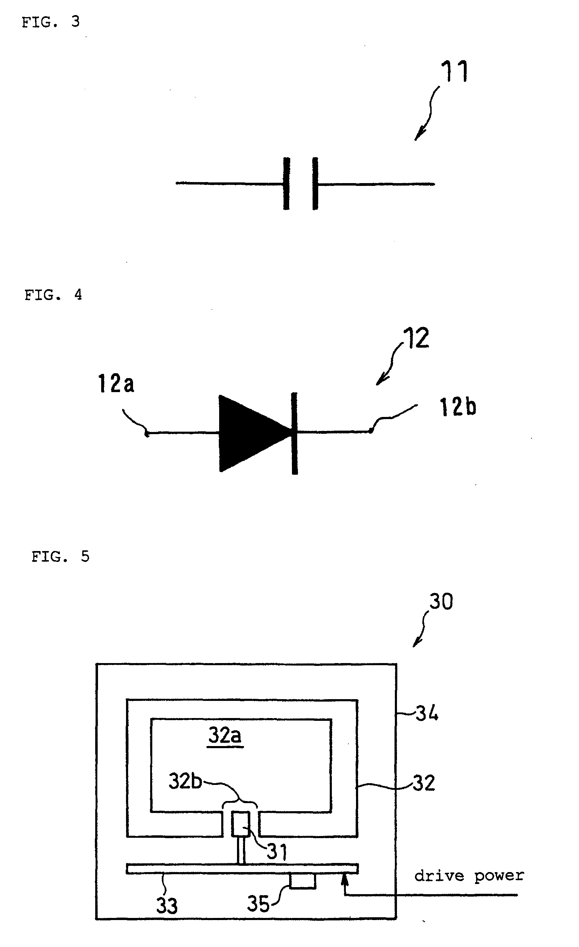

FIG. 5 illustrates an example of a conventional current sensor using a Hall element. The current sensor 30 of FIG. 5 comprises a Hall element 31, a core (magnetic body) 32, a circuit board 33 to which the Hall element 31 is attached, and a cabinet 34. The core 32 is a ring-shaped component having inside a conductor insertion portion 32a through which a conductor (not illustrated), through which a target current flows, is inserted. Provided at a part of the ring is a gap 32b where the Hall element 31 is disposed.

The core 32 is formed of a magnetic body with small magnetic resistance such as ferrite, a silicon steel sheet, and permalloy, and serves to collect interlinkage magnetic flux generated around the above conductor inserted through the conductor insertion portion 32a. The Hall element 31 outputs an electric signal (voltage) corresponding to the amount of the magnetic flux collected by the core 32. Also, in addition to the Hall element 31, an amplifier circuit (not illustrated) for amplifying the output signal from the Hall element 31 is disposed on the circuit board 33.

In addition, in the current sensor 30, a protection element 35 in the form of a capacitor, a Zener diode, or the like is provided on the circuit board 33. The protection element 35 is for protecting the components (e.g., the above amplifier circuit) inside the current sensor 30 from static electricity applied via a supply line for the drive power which drives the Hall element 31 and the above amplifier circuit.
Further, PTL 1 discloses a technique for protecting electronic equipments from extraneous surges that come through a power line.

### [Citation List]

### [Patent Literature]

[PTL 1] Japanese Laid-Open Patent Publication No. 2000-156930

### [Summary of Invention]

### [Technical Problem]

As described above, a current sensor using a Hall element is used in various fields, and is also useful in that it can safely measure currents of power sources having characteristics of high voltage and high output, particularly due to its high insulation for the target currents. Due to such a reason, a current sensor using a Hall element is also used for measuring output currents of battery packs serving as the power source for driving hybrid vehicles.

Such battery packs are assembled of a plurality of secondary batteries connected to one another so as to obtain high voltage and high output, and sufficient care is required for their handling, since, while having characteristics of high voltage and high output, the current that flows out and the amount of heat generated are large when there is an electricity leakage.
Thus, since the current sensor also needs to have sufficient insulation, its cabinet is preferably made of an insulating material. However, when the cabinet is made of an insulating material, static electricity generated outside may transfer to the wall portion of the cabinet and then to the core.

On the other hand, insulation between the core and the Hall element is usually secured by a gap therebetween. Since the gap between the core and the Hall element needs to be as small as possible to increase sensitivity of the Hall element, there may be contact between the core and the Hall element, caused due to variation in production of the current sensors. In such a case, there is the problem of the properties of the Hall element degrading due to static electricity which has transferred from the wall portion of the cabinet to the core, subsequently transferring to the Hall element.

With respect to this problem, all of the above conventional techniques try to protect the components inside the current sensor from static electricity or the like which transfers to the inside of the current sensor via a conductive line. Therefore, the above conventional techniques are not capable of protecting the Hall element from static electricity which transfers to the inside of the current sensor via the cabinet thereof.
An object of the present invention, which is made in view of the above problem, is to provide a current sensor capable of preventing a Hall element therein from degrading due to static electricity.

### [Solution to Problem]

In order to realize the above object, a current sensor of the present invention comprises: a magnetic body for collecting magnetic flux generated by a target current; a Hall element for outputting an electric signal corresponding to the amount of the magnetic flux collected by the magnetic body; an amplifier for amplifying the output signal from the Hall element; and a circuit board to which the Hall element and the amplifier are attached, the current sensor having a conducting means for allowing conduction between the magnetic body and the circuit board.

Herein, the conducting means preferably comprises at least one selected from the group consisting of a resistor, a capacitor, a diode, and a varistor.

In addition, the conducting means also preferably comprises a conductive adhesive.

Further, a cabinet comprising an insulating material for accommodating the magnetic body, the Hall element, the amplifier, and the circuit board, is also preferably provided.

### [Advantageous Effects of Invention]

According to the present invention, since there is conduction between the magnetic body and the circuit board by the conducting means, even when static electricity generated outside transfers to the magnetic body from the wall portion of the cabinet being an insulating body, such static electricity can be transferred to the circuit board via the conductive means. Therefore, static electricity exceeding a specified level is prevented from being applied to the Hall element from the magnetic body. This can prevent the properties of the Hall element from degrading.

### [Brief Description of Drawings]

[FIG. 1] A front view of the schematic configuration of a current sensor according to Embodiment 1 of the present invention, seen through a cabinet thereof.
[FIG. 2] A plan view of a circuit board in the apparatus of FIG. 1.
[FIG. 3] A view of a capacitor represented by a circuit symbol, the capacitor used in a current sensor according to Embodiment 2 of the present invention.
[FIG. 4] A view of a diode represented by a circuit symbol, the diode used in a current sensor according to Embodiment 3 of the present invention.
[FIG. 5] A front view of the schematic configuration of a conventional current sensor, seen through a cabinet thereof.

### [Description of Embodiments]

### (Embodiment 1)

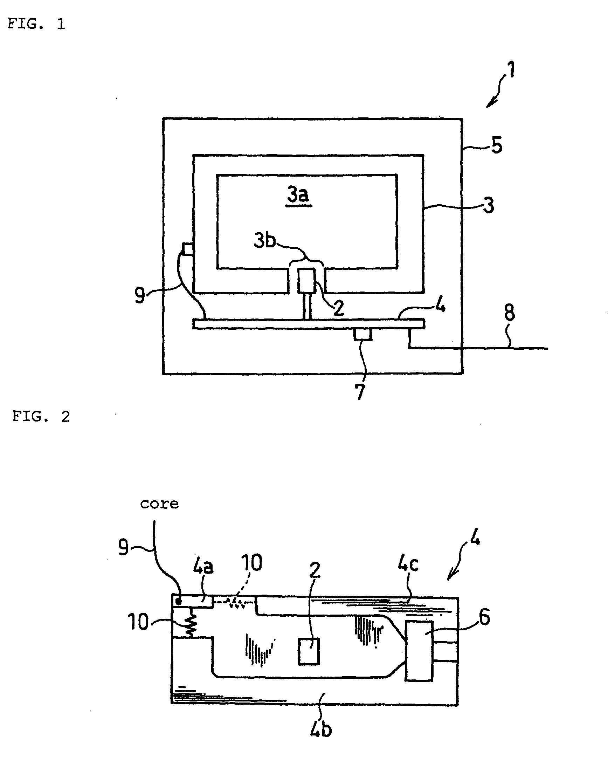

In the following, an embodiment of the present invention will be described with reference to drawings. FIG. 1 is a front view of a current sensor according to an embodiment of the present invention, seen through a cabinet thereof. FIG. 2 is a plan view of a circuit board in the apparatus of FIG. 1.

The current sensor 1 of FIG. 1 comprises a Hall element 2, a core (magnetic body) 3, the circuit board 4, and a cabinet 5 made of an insulating material. The core 3 is a ring-shaped component having inside a conductor insertion portion 3a through which a conductor (not illustrated), through which a target current flows, is inserted. Provided at a part of the ring is a gap 3b where the Hall element 2 is disposed.

The core 3 is formed of a magnetic body with small magnetic resistance such as ferrite, a silicon steel sheet, and permalloy, and serves as a magnetism collecting means for collecting interlinkage magnetic flux generated around the above conductor due to the current in the above conductor. The Hall element 2 outputs an electric signal for voltage corresponding to the amount of the magnetic flux collected by the core 3. Attached to the circuit board 4 is the Hall element 2, and also an amplifier circuit 6 for amplifying the output signal from the Hall element 2. Also, the circuit board 4 has a connecting wire 4a of a connecting line 9 that will be described below, a grounding wire 4b, and a power supply wire 4c. With respect to power terminals (not illustrated) of the amplifier circuit 6, one is connected to the grounding wire 4b, and the other is connected to the power supply wire 4c.
Also, in the current sensor 1, a protection element 7 in the form of a capacitor, a Zener diode, or the like is provided on the circuit board 4. The protection element 7 is for protecting the amplifier circuit 6, etc. from static electricity applied via a supply line 8 for the drive power to drive the Hall element 2 and the amplifier circuit 6.

Further, the current sensor 1 comprises a connecting line 9 which allows conduction between the core 3 and the circuit board 4, in order for static electricity which has transferred from the cabinet 5, etc. to the core 3, to subsequently transfer to the circuit board 4. As illustrated in FIG. 2, the connecting line 9 is connected to the connecting wire 4a provided on the circuit board 4. Herein, it is preferable that, in terms of excluding lead, the connecting line 9 is connected to the core 3 and the connecting wire 4a with a conductive adhesive, in which a conductive filler of a gold powder, a silver powder, a copper power, or the like is closely packed inside a resin.

In addition, the connecting wire 4a is preferably connected, for example, to the grounding wire 4b via a resistor 10. This enables static electricity from the core 3 to escape via the connecting line 9, the connecting wire 4a, the resistor 10, and the grounding wire 4b.

Herein, allowing static electricity from the core 3 to escape via the resistor 10, is to adjust so that voltage generated when static electricity flows through the resistor 10 does not exceed the withstand voltage of the Hall element 2. Thus, even if static electricity is applied from the core 3 to the Hall element 2, the applied voltage can be made sufficiently lower than the withstand voltage of the Hall element 2, and the Hall element 2 can be prevented from degrading. At this time, the resistance value of the resistor 10 can be selected as appropriate from the range of, for example, 0.1 to 100 Ω. This is because the desired resistance value of the resistor 10 would be 1.8 Ω, assuming that static electricity of the human body model is usually 1.5 kΩ, withstand voltage of the Hall element is 30 V, and electrostatic charge of 25 kV is present. Also, the resistor used for the resistor 10 is preferably a resistive element having excellent electrostatic capacity. However, when using a Hall element with an extremely low withstand voltage as the Hall element 2, it may be necessary to make the resistance value of the resistor 10 smaller than the lower limit of the above range, depending on that withstand voltage.

As described above, according to the current sensor of Embodiment 1, static electricity which transfers from the cabinet 5 to the core 3 escapes to the circuit board 4 via the connecting line 9. Therefore, static electricity which has transferred to the core 3 from the wall portion of the cabinet 5 is applied even further to the Hall element 2, and properties of the Hall element 2 can be prevented from degrading.

### (Embodiment 2)

Next, Embodiment 2 of the present invention will be described. Embodiment 2 is a modification of Embodiment 1, and the following describes only the part differing from Embodiment 1. In Embodiment 2, instead of the resistor 10, a capacitor 11 as illustrated in FIG. 3 is disposed between the connecting wire 4a and the grounding wire 4b.

Herein, the capacity of the capacitor 11 can be selected as appropriate from the range of, for example, 0.01 to 1 µF. This is because the desired capacity of the capacitor 11 would be about 0.1 µF, assuming that static electricity of the human body model is usually 150 pF, withstand voltage of the Hall element is 30 V, and electrostatic charge of 25 kV is present.
As such, even when the capacitor 11 is disposed between the connecting wire 4a and the grounding wire 4b instead of the resistor 10, voltage applied to the Hall element 2 by way of the core 3 can be made sufficiently lower than the withstand voltage of the Hall element 2, and the Hall element 2 can be prevented from degrading.

### (Embodiment 3)

Next, Embodiment 3 of the present invention will be described. Embodiment 3 is a modification of Embodiment 1, and the following only describes the part differing from Embodiment 1. In Embodiment 3, instead of the resistor 10, a diode 12 as illustrated in FIG. 4 is disposed between the connecting wire 4a and the grounding wire 4b. At this time, the anode terminal of the diode 12 is connected to the connecting wire 4a, and the cathode terminal thereof is connected to the grounding wire 4b.

As such, even when the diode 12 is disposed between the connecting wire 4a and the grounding wire 4b instead of the resistor 10, voltage applied to the Hall element 2 by way of the core 3 can be made sufficiently lower than the withstand voltage of the Hall element 2, and the Hall element 2 can be prevented from degrading. This is because, when a silicon diode is used as the diode 12, the voltage equivalent to the voltage drop (about 0.6 V) is sufficiently smaller than the withstand voltage of the Hall element 2. In addition, also when a reference diode (Zener diode) is used as the diode 12, it is important to set that voltage to be smaller than the withstand voltage of the Hall element 2.

The embodiments of the present invention have been described as above; however, the present invention is capable of various modifications. For example, even if a varistor is used instead of the resistor 10, the same effect as each of those from the above embodiments can be achieved. Also, any two of the resistor 10, the capacitor 11, the diode 12, and the varistor, or, in the alternative, all of the above, may be disposed between the connecting wire 4a and the grounding wire 4b.

In addition, the conductive wire 4a and the grounding wire 4b may be connected simply by a conductive line. Cost reduction is possible in this case, since circuit components such as the resistor, the capacitor, etc. can be omitted. However, in instances such as a direct contact caused between the core 3 and the above conductor which passes through the conductor insertion portion 3a thereof, it would not be possible to limit the current that flow from the core 3 to the circuit board 4. As a result, it would not be possible to protect each element on the circuit board 4, and also, to limit the current that leak to the outside, thereby making it difficult to secure safety. Therefore, the connecting wire 4a and the grounding wire 4b are connected directly to each other, preferably only in the case where countermeasures can be taken to avoid such a disadvantage.

Further, as illustrated as a broken line in FIG. 2, the connecting wire 4a, that is, the connecting line 9 may be connected to the power supply wire 4c which supplies power to the amplifier circuit 6 and the Hall element 2. A low voltage (e.g., 5V) is applied to the power supply wire 4c, but the Hall element 2 is not adversely affected even when a voltage of such level is applied to the core 3 via the connecting line 9, etc.
Furthermore, without question, it is possible to connect the connecting wire 4b or the power supply wire 4c directly to the core 3 by the connecting line 9. However, in this case also, there would be an occurrence of the same problem as that caused when the connecting wire 4a and the grounding wire 4b are simply connected by a conductive line, as described above.

### [Industrial Applicability]

According to the current sensor of the present invention, when the cabinet is made of an insulating material for increased insulation, the properties of the Hall element can be prevented from degrading due to static electricity which transfers from the cabinet to the core. Therefore, the present invention is useful as a current sensor for measuring currents of power sources, particularly of those having characteristics of high voltage and high output.

### [Reference Signs List]

- 1: current sensor
- 2: Hall element
- 3: core (magnetic body)
- 4: circuit board
- 5: cabinet
- 6: amplifier circuit
- 9: connecting line
- 10: resistor
- 11: capacitor
- 12: diode

## Claims

1. A current sensor comprising:
a magnetic body for collecting magnetic flux generated by a target current;
a Hall element for outputting an electric signal corresponding to the amount of the magnetic flux collected by said magnetic body;
an amplifier for amplifying the output signal from said Hall element; and
a circuit board to which said Hall element and said amplifier are attached,
said current sensor having a conducting means for allowing conduction between said magnetic body and said circuit board.

2. The current sensor in accordance with claim 1, wherein said conducting means comprises at least one selected from the group consisting of a resistor, a capacitor, a diode, and a varistor.

3. The current sensor in accordance with claim 1 or 2, wherein said conducting means comprises a conductive adhesive.

4. The current sensor in accordance with any of claims 1 to 3, further comprising a cabinet comprising an insulating material, for accommodating said magnetic body, said Hall element, said amplifier, and said circuit board.
